# EUROPÄISCHE PATENTSCHRIFT

(11) **EP 1 410 450 B1**
(45) Veröffentlichungstag und Bekanntmachung des Hinweises auf die Patenterteilung: **12.01.2011**
(21) Anmeldenummer: 02760080.8
(22) Anmeldetag: 05.07.2002
(51) Int. Cl.: H01L 51/50

(54) **LICHTEMITTIERENDES BAUELEMENT MIT ORGANISCHEN SCHICHTEN**
LIGHT EMITTING COMPONENT WITH ORGANIC LAYERS
COMPOSANT ELECTROLUMINESCENT A COUCHES ORGANIQUES

(30) Priorität: 20.07.2001 DE 10135513
(43) Veröffentlichungstag der Anmeldung: 21.04.2004
(73) Patentinhaber: Novaled AG, 01307 Dresden (DE)
(72) Erfinder: LEO, Karl, D-01219 Dresden (DE); BLOCHWITZ-NIMOTH, Jan, 01069 Dresden (DE); PFEIFFER, Martin, 01139 Dresden (DE)
(74) Vertreter: Bittner, Thomas L.
(86) Internationale Anmeldenummer: PCT/DE2002/002467
(87) Internationale Veröffentlichungsnummer: WO 2003/012890

(56) Entgegenhaltungen:
- EP-A- 0 498 979
- EP-A- 1 017 117
- EP-A- 1 017 118
- WO-A-98/10473
- WO-A1-97/20355
- US-A- 5 981 092
- US-A- 6 046 543
- PATENT ABSTRACTS OF JAPAN vol. 2000, no. 07, 29. September 2000 (2000-09-29) & JP 2000 100559 A (MATSUSHITA ELECTRIC IND CO LTD), 7. April 2000 (2000-04-07)
- YAMAMORI A ET AL: "DOPED ORGANIC LIGHT EMITTING DIODES HAVING A 650-NM-THICK HOLE TRANSPORT LAYER" APPLIED PHYSICS LETTERS, AMERICAN INSTITUTE OF PHYSICS. NEW YORK, US, Bd. 72, Nr. 17, 27. April 1998 (1998-04-27), Seiten 2147-2149, XP000754421 ISSN: 0003-6951
- BLOCHWITZ J ET AL: "LOW VOLTAGE ORGANIC LIGHT EMITTING DIODES FEATURING DOPED PHTHALOCYANINE AS HOLE TRANSPORT MATERIAL" APPLIED PHYSICS LETTERS, AMERICAN INSTITUTE OF PHYSICS. NEW YORK, US, Bd. 73, Nr. 6, 10. August 1998 (1998-08-10), Seiten 729-731, XP000774933 ISSN: 0003-6951
- ZHOU X ET AL: "VERY-LOW-OPERATING-VOLTAGE ORGANIC LIGHT-EMITTING DIODES USING A P-DOPED AMORPHOUS HOLE INJECTION LAYER" APPLIED PHYSICS LETTERS, AMERICAN INSTITUTE OF PHYSICS. NEW YORK, US, Bd. 78, Nr. 4, 22. Januar 2001 (2001-01-22), Seiten 410-412, XP000994455 ISSN: 0003-6951 in der Anmeldung erwähnt
- ZHOU X ET AL: "ENHANCED HOLE INJECTION INTO AMORPHOUS HOLE-TRANSPORT LAYERS OF ORGANIC LIGHT-EMITTING DIODES USING CONTROLLED P-TYPE DOPING" ADVANCED FUNCTIONAL MATERIALS, WILEY INTERSCIENCES, WIENHEIM, DE, Bd. 11, Nr. 4, August 2001 (2001-08), Seiten 310-314, XP001042080 ISSN: 1616-301X
- ZHOU X. ET AL: 'Low-voltage inverted transparent vacuum deposited organic light-emitting diodes using electrical doping' APPLIED PHYSICS LETTERS Bd. 81, Nr. 5, 29 Juli 2002, AIP, AMERICAN INSTITUTE OF PHYSICS, MELVILLE, NY, US, Seiten 922 - 924, XP012033136
- DOBBERTIN T. ET AL: 'INVERTED HYBRID ORGANIC LIGHT-EMITTING DEVICE WITH POLYETHYLENE DIOXYTHIOPHENE-POLYSTRYRENE SULFONATE AS AN ANODE BUFFER LAYER' APPLIED PHYSICS LETTERS Bd. 83, Nr. 24, 15 Dezember 2003, AIP, AMERICAN INSTITUTE OF PHYSICS, MELVILLE, NY, US, Seiten 5071 - 5073, XP001195003
- PARTHASARATHY G. ET AL: 'A METAL-FREE CATHODE FOR ORGANIC SEMICONDUCTOR DEVICES' APPLIED PHYSICS LETTERS Bd. 72, Nr. 17, 27 April 1998, AIP, AMERICAN INSTITUTE OF PHYSICS, MELVILLE, NY, US, Seiten 2138 - 2140, XP000754419
- HUNG L.S. ET AL: 'INTERFACE ENGINEERING IN PREPARATION OF ORGANIC SURFACE-EMITTING DIODES' APPLIED PHYSICS LETTERS Bd. 74, Nr. 21, 24 Mai 1999, AIP, AMERICAN INSTITUTE OF PHYSICS, MELVILLE, NY, US, Seiten 3209 - 3211, XP000834778
- LI F. ET AL: 'FABRICATION AND ELECTROLUMINESCENCE OF DOUBLE-LAYERED ORGANIC LIGHT-EMITTING DIODES WITH THE AL2O3/AL CATHODE' APPLIED PHYSICS LETTERS Bd. 70, Nr. 10, 10 März 1997, AIP, AMERICAN INSTITUTE OF PHYSICS, MELVILLE, NY, US, Seiten 1233 - 1235, XP000685285
- HUNG L.S. ET AL: 'ENHANCED ELECTRON INJECTION IN ORGANIC ELECTROLUMINESCENCE DEVICES USING AN AI/LIF ELECTRODE' APPLIED PHYSICS LETTERS Bd. 70, Nr. 2, 13 Januar 1997, AIP, AMERICAN INSTITUTE OF PHYSICS, MELVILLE, NY, US, Seiten 152 - 154, XP000680570
- CAMPBELL I.H. ET AL: 'Controlling charge injection in organic electronic devices using self-assembled monolayers' APPLIED PHYSICS LETTERS Bd. 71, Nr. 24, 15 Dezember 1997, AIP, AMERICAN INSTITUTE OF PHYSICS, MELVILLE, NY, US, Seiten 3528 - 3530, XP012019268
- PARTHASARATHY G. ET AL: 'HIGH-EFFICIENCY TRANSPARENT ORGANIC LIGHT-EMITTING DEVICES' APPLIED PHYSICS LETTERS Bd. 76, Nr. 15, 10 April 2000, AIP, AMERICAN INSTITUTE OF PHYSICS, MELVILLE, NY, US, Seiten 2128 - 2130, XP000950183
- MAITROT M. ET AL: 'MOLECULAR MATERIAL BASED JUNCTIONS: FORMATION OF A SCHOTTKY CONTACT WITH METALLOPHTHALOCYANINE THIN FILMS DOPED BY THE COSUBLIMATION METHOD' JOURNAL OF APPLIED PHYSICS Bd. 60, Nr. 7, 01 Oktober 1986, AMERICAN INSTITUTE OF PHYSICS. NEW YORK, US, Seiten 2396 - 2400, XP008062610
- BURROWS P.E. ET AL: 'Semitransparent cathodes for organic light emitting devices' JOURNAL OF APPLIED PHYSICS Bd. 87, Nr. 6, 15 März 2000, AMERICAN INSTITUTE OF PHYSICS. NEW YORK, US, Seiten 3080 - 3085, XP002385531
- ITOH Y. ET AL EXTENDED ABSTRACTS OF THE 51 AUTUMN MEETING 1990, THE JAPANESE SOCIETY OF APPLIED PHYSICS, Seite 1040
- KIM H.-K. ET AL: 'Plasma damage-free sputtering of indium tin oxide cathode layers for top-emitting organic light-emitting diodes' APPLIED PHYSICS LETTERS Bd. 86, Nr. 18, 29 April 2005, Seiten 183503 - 183505-3, XP012065285

## Beschreibung

Die Erfindung betrifft ein lichtemittierendes Bauelement mit organischen Schichten, insbesondere eine organische Leuchtdiode nach dem Oberbegriff des Anspruchs 1.

Organische Leuchtdioden sind seit der Demonstration niedriger Arbeitsspannungen von Tang et al. 1987 [C.W. Tang et al., Appl. Phys. Lett. 51 (12), 913 (1987)] aussichtsreiche Kandidaten für die Realisierung großflächiger Displays. Sie bestehen aus einer Folge dünner (typischerweise 1nm bis 1µm) Schichten aus organischen Materialien, welche bevorzugt im Vakuum aufgedampft oder aus der Lösung z.B. durch Schleudern aufgebracht werden. Nach elektrischer Kontaktierung durch Metallschichten bilden organische Dünnschichten vielfältige elektronische oder optoelektronische Bauelemente, wie z.B. Dioden, Leuchtdioden, Photodioden und Transistoren, die mit ihren Eigenschaften den etablierten Bauelementen auf der Basis anorganischer Schichten Konkurrenz machen.

Im Falle der organischen Leuchtdioden (OLEDs) wird durch die Injektion von Ladungsträgern (Elektronen von der einen, Löcher von der anderen Seite) aus den Kontakten in die dazwischen befindlichen organischen Schichten infolge einer äußeren angelegten Spannung, der folgenden Bildung von Exzitonen (Elektron-Loch-Paaren) in einer aktiven Zone und der strahlenden Rekombination dieser Exzitonen, Licht erzeugt und von der Leuchtdiode emittiert.

Der Vorteil solcher Bauelemente auf organischer Basis gegenüber den konventionellen Bauelementen auf anorganischer Basis (Halbleiter wie Silizium, Galliumarsenid) besteht darin, dass es möglich ist, sehr großflächige Anzeigeelemente (Bildschirme, Screens) herzustellen. Die organischen Ausgangsmaterialien sind gegenüber den anorganischen Materialien relativ preiswert (geringer Material- und Energieaufwand). Obendrein können diese Materialien aufgrund ihrer gegenüber anorganischen Materialien geringen Prozeßtemperatur auf flexible Substrate aufgebracht werden, was eine ganze Reihe von neuartigen Anwendungen in der Display- und Beleuchtungstechnik eröffnet.
Die übliche Anordnung solcher Bauelemente stellt eine Folge aus einer oder mehrerer der folgenden Schichten dar:
1. Träger, Substrat
2. Basiselektrode, löcherinjizierend (Pluspol), transparent,
3. Löcher injizierende Schicht,
4. Löcher transportierende Schicht (HTL),
5. Licht emittierende Schicht (EL),
6. Elektronen transportierende Schicht (ETL),
7. Elektronen injizierende Schicht,
8. Deckelektrode, meist ein Metall mit niedriger Austrittsarbeit, elektroneninjizierend (Minuspol),
9. Kapselung, zum Ausschluß von Umwelteinflüssen.
Dies ist der allgemeinste Fall, meistens werden einige Schichten weggelassen (außer 2, 5 und 8.), oder aber eine Schicht kombiniert in sich mehrere Eigenschaften.

Der Lichtaustritt erfolgt bei der beschriebenen Schichtfolge durch die transparente Basiselektrode und das Substrat, während die Deckelektrode aus nicht transparenten Metallschichten besteht. Gängige Materialien dafür sind Indium-Zinn-Oxid. (ITO) und verwandte Oxidhalbleiter als Injektionskontakt für Löcher (ein transparenter entarteter Halbleiter). Für die Elektroneninjektion kommen unedle Metalle wie Aluminium. (Al), Magnesium (Mg), Kalzium (Ca) oder eine Mischschicht aus Mg und Silber (Ag) oder solche Metalle in Kombination mit einer dünnen Schicht eines Salzes wie Lithiumfluorid (LiF) zum Einsatz.

Aus der EP 1017118 und aus der EP 0489979 sind nicht invertierte OLED bekannt, die eine Dotierung in der Löchertransportschicht aufweisen, wodurch eine größere Leitfähigkeit einstellbar sein soll und eine derartige OLED dann mit niedrigeren Betriebsspannungen betrieben werden könnte.

Für viele Anwendungen ist es jedoch wünschenswert, dass die Lichtemission nicht zum Substrat hin, sondern durch die Deckelektrode erfolgt. Beispiele hierfür sind Displays auf der Basis organischer Leuchtdioden, die auf Siliziumsubstraten oder Plastiksubstraten aufgebaut werden (z.B. US Patent Nr. 5,736,754 (S.Q. Shi et al.), eingereicht am 17. 11. 1995; US Patent Nr. 5,693,956 (S.Q. Shi et al.), eingereicht am 29.6.1996), bzw. Displays; bei denen eine strukturierte Filterschicht oder Absorberschicht auf die organischen Leuchtdioden aufgebracht werden soll (z.B. US Patent Nr. 6,137,221 (D.B. Roitman et al.), eingereicht am 8. 7. 1998; C. Hosokawa et al., Synthet. Metal., 91, 3-1 (1997); G. Rajeswaran et al., SID 00 Digest, 40.1 (2000))

Diese Emission durch die Deckelektrode kann für die oben beschriebene Reihenfolge der organischen Schichten (Deckelektrode ist die Kathode) dadurch erreicht werden, dass ein sehr dünne herkömmliche Metallelektrode aufgebracht wird. Da diese bei einer Dicke, welche hinreichend hohe Transmisssion aufweist, noch keine hohe Querleitfähigkeit erreicht, muss darauf noch ein transparentes Kontaktmaterial aufgebracht werden, z.B. ITO oder Zink dotiertes Indium-Oxid (z.B. US Patent Nr. 5,703,436 (S.R. Forrest et al.), eingereicht am 6.3.1996; US Patent Nr. 5,757,026 (S.R. Forrest et al.), eingereicht am 15.4.1996; US Patent Nr. 5,969,474 (M. Arai), eingereicht am 24.10.1997). Weitere bekannte Realisierungen dieser Struktur sehen eine organische Zwischenschicht zur Verbesserung der Elektronen-Injektion vor (z.B. G. Parthasarathy et al., Appl. Phys. Lett. 72, 2138 (1997); G. Parthasarathy et al., Adv. Mater. 11, 907 (1997)), welche teilweise durch Metallatome wie Lithium dotiert sein kann (G. Parthasarathy et al., Appl. Phys. Lett., 76, 2128 (2000)). Auf diese wird dann eine transparente Kontaktschicht (meistens ITO) aufgebracht. Allerdings ist ITO schlecht zur Elektroneninjektion geeignet (Kathode), was die Betriebsspannungen einer solchen LED erhöht.

Die alternative Möglichkeit zur transparenten Kathode besteht im Umdrehen der Schichtreihenfolge, also der Ausführung des löcherinjizierenden transparenten Kontaktes: (Anode) als Deckelektrode. Eine derartige Lösung ist aus der US 604 64 43 bekannt.

Die Realisierung solcher invertierter Strukturen mit der Anode auf der LED bereitet in der Praxis jedoch erhebliche Schwierigkeiten. Metallelektroden, die eine akzeptable Transparenz aufweisen, müssen hinreichend dünn sein, so dass sich oft keine geschlossene Schicht bildet bzw. die Querleitfähigkeit nicht ausreicht, um einen homogenen Stromfluß durchs das Bauelement herbeizuführen. Wenn die Schichtfolge durch die löcherinjizierende Schicht abgeschlossen wird, so ist es erforderlich, das gebräuchliche Material für die Löcherinjektion ITO (oder ein alternatives Material) auf die organische Schichtfolge aufzubringen (z.B. US Patent Nr. 5,981,306 (P. Burrows et al.), eingereicht am 12.9.1997). Dies verlangt meist Prozeßtechnologien, die mit den organischen Schichten schlecht verträglich sind und unter Umständen zur Beschädigung führen. Eine Verbesserung können hier Schutzschichten erzielen, welche aber die Betriebsspannung des Bauelementes wieder erhöhen, da sie die gesamte organische Schichtdicke erhöhen (US Patent Nr. 6,046,543 (V. Bulovic et al.), eingereicht am 23.12.1996; Z. Shen, Science 276, 2009 (1997)).

Ein noch wesentlich schwerer wiegender Nachteil ist die Tatsache, dass die herkömmliche Herstellungsmethode der Leuchtdioden verlangt, dass die löcherinjizierende Schicht eine möglichst hohe Austrittsarbeit aufweist. Dies ist notwendig, da die organischen Schichten nominell undotiert sind und deswegen eine effiziente Injektion nur möglich ist, wenn eine möglichst niedrige Potentialbarriere vorhanden ist. Zur Erzielung niedriger Betriebsspannungen und hoher Effizienzen ist es deswegen notwendig, eine spezifische Präparation der Oberfläche des löcherinjizierenden Materials vorzunehmen (z.B. C.C. Wu et al., Appl. Phys Lett. 70, 1348 (1997); G. Gu et al., Appl. Phys. Lett. 73, 2399 (1998)). Die Austrittsarbeit von ITO kann z.B. durch Ozonierung und/oder Sauerstoff-Plasma Veraschung von ca. 4.2eV bis zu ca. 4.9eV verändert werden. Dies hat einen großen Einfluß auf die Effizienz der Löcherinjektion und damit die Betriebsspannung einer OLED. Beim Aufbringen des löcherinjizierenden Materials auf die organischen Schichten können diese Methoden der Oberflächenpräparation nicht angewandt werden. Dies hat dazu geführt, dass bei invertierten organischen Leuchtdioden die Betriebsspannungen gewöhnlich wesentlich höher sind, was zu niedrigeren Leistungseffizienzen (Lichtemission im Verhältnis zur elektrischen Leistung) führt (z.B. V. Bulovic et al., Appl. Phys. Lett. 70, 2954 (1997)).

Aus den genannten Gründen existiert bisher noch keine invertierte Struktur, welche gleich gute optoelektronische Kenndaten aufweist wie eine entsprechende nicht-invertierte Struktur. Das heisst, dass die Betriebsspannungen solcher invertierter OLEDs höher und die Effizienzen niedriger sind im Vergleich zu OLEDs mit herkömmlichem Schichtaufbau.

Die invertierte Anordnung erlaubt eine einfache Integration der OLED mit Standard-Treiberelektronik, wie CMOS-Technologie mit amorphen Si-NFETs. Darüber hinaus hat die Anordnung der Kathode unterhalb der organischen Schichten den Vorteil, dass sie besser vor Umwelteinflüssen wie Sauerstoff und Wasser geschützt ist. Wie bekannt hat dies negative Einflüsse auf die Langzeitstabilität, z.B. durch Ablöseerscheinungen der Deckelektrode. Da das klassische löcherinjizierende transparente Anodenmaterial ITO bereits selbst Sauerstoff enthält, sollten diese Effekte bei einer invertierten Struktur reduziert werden können. Ein weiterer Vorteil der invertierten Struktur besteht darin, dass als Substrat ein sehr flaches Halbleitersubstrat verwendet werden kann, während bei der klassischen Struktur mit ITO als Grundkontakt eine gewisse Restrauhigkeit des ITO nicht vermieden werden kann. Dies kann aufgrund von Pin-Holes (partiellen Durchkontaktierungen) zu Problemen mit der Langzeitstabilität führen.

Für Leuchtdioden aus anorganischen Halbleitern ist seit langem bekannt, dass durch hochdotierte Randschichten dünne Raumladungszonen erreicht werden können, die auch bei vorhandenen energetischen Barrieren durch Tunneln zu effizienter Injektion von Ladungsträgern führen. Die Dotierung organischer Materialien wurde im US Patent Nr. 5,093,698, eingereicht am 12.2.1991, beschrieben. Dies führt aber bei praktischen Anwendungen zu Problemen mit der Energieangleichung der verschiedenen Schichten und Verminderung der Effizienz der LEDs mit dotierten Schichten. Dies kann durch die Wahl geeigneter Blockschichten verbessert werden (Patent Anmeldung DE 100 58 578.7, eingereicht am 25.11.2000).

Aus dem Dokument US 6,046,543 ist eine organische lichtemittierende Diode mit invertierter Struktur bekannt. Ein organisches lichtemittierendes Bauelement mit ebenfalls invertierter Struktur wird in dem Dokument WO 97/20355 beschrieben. In eine Löchertransportschicht werden bei dem bekannten Bauelement Einlagerungen aus einem anorganischen Material eingebracht.

Organische lichtemittierende nicht invertierte Bauelemente mit organischen p-Dotanten in der Löchertransport-Schicht sind weiterhin in folgenden Dokumenten offenbart: Blochwitz et al., Applied Physics Letters, Bd. 73, Nr. 6, 729-731 und Yamamori et al., Applied Physics Letters, Bd. 72, Nr. 17, 2147-2149.

Ein organisches lichtemittierendes Bauelement in invertierter und nicht invertierter Struktur ist weiterhin aus dem Dokument US 5,981,092 bekannt. Bei dem Bauelement ist eine Schicht aus anorganischem Material zwischen einer Elektrode und einer lichtemittierenden Schicht gebildet. Das Dokument WO 98/10473 betrifft organische lichtemittierende Bauelemente.

Die Aufgabe der Erfindung besteht darin, eine durch den Deckkontakt Licht emittierende invertierte organische Leuchtdiode anzugeben, die mit einer verringerten Betriebsspannung betrieben werden kann und eine erhöhte Lichtemissionseffizienz aufweist. Gleichzeitig soll der Schutz aller organischer Schichten vor Schäden infolge der Herstellung des transparenten Deckkontaktes gewährleistet sein (als transparent werden im Sinne der Erfindung alle Schichten mit einer Transmission von >50% im Bereich der Lichtemission der OLED bezeichnet). Erfindungsgemäß wird die Aufgabe durch ein lichtemittierendes Bauelement nach dem unabhängigen Anspruch 1 gelöst.

Durch die p-dotierte Löchertransportschicht an der Anode zu dem löcherinjizierenden Material wird eine dünne Raumladungszone erreicht, durch die die Ladungsträger effizient injiziert werden können. Aufgrund der. Tunnelinjektion wird durch die sehr dünne Raumladungszone die Injektion auch bei einer energetisch hohen Barriere nicht mehr behindert. Vorteilhaft ist die Ladungsträgertransportschicht durch eine Beimischung einer organischen Substanz (Dotand) dotiert. Durch die erhöhte Leitfähigkeit der dotierten organischen Schicht kann diese dick genug ausgeführt sein, um alle darunterliegenden Schichten vor Schäden infolge der Herstellung des transparenten Deckkontaktes zu schützen.

Aus X. Zhou et al., Appl. Phys. Lett. 78, 410 (2001)) ist bekannt, dass organische Leuchtdioden mit dotierten Transportschichten nur effiziente Lichtemission zeigen, wenn die dotierten Transportschichten auf geeignete Weise mit Blockschichten kombiniert werden. In einer vorteilhaften Ausführungsform werden deshalb die invertierten Leuchtdioden ebenfalls mit Blockschichten versehen. Die Blockschicht befindet sich jeweils zwischen der Ladungsträgertransportschicht und einer lichtemittierenden Schicht des Bauelementes, in welcher die Umwandlung der elektrischen Energie der durch Stromfluß durch das Bauelement injizierten Ladungsträger in Licht stattfindet. Die Substanzen der Blockschichten werden erfindungsgemäß so gewählt, daß sie bei angelegter Spannung (in Richtung der Betriebsspannung) aufgrund ihrer Energieniveaus die Majoritätsladungsträger (HTL-Seite: Löcher, ETL-Seite: Elektronen) an der Grenzschicht dotierte Ladungsträgertransportschicht/Blockschicht nicht zu stark behindert wird (niedrige Barriere), aber die Minoritätsladungsträger effizient an der Grenzschicht Licht emittierende Schicht/Blockschicht aufgehalten werden (hohe Barriere).

Eine vorteilhafte Ausführung einer Struktur einer erfindungsgemäßen invertierten OLED beinhaltet folgende Schichten:
1. Träger, Substrat,
2. Elektrode, meist ein Metall mit niedriger Austrittsarbeit, elektroneninjizierend (Kathode=Minuspol),
3. n-dotierte, Elektronen injizierende und transportierende Schicht,
4. dünne elektronenseitige Blockschicht aus einem Material dessen Bandlagen zu den Bandlagen der sie umgebenden Schichten passt,
5. lichtemittierende Schicht (evtl. mit Emitterfarbstoff dotiert),
6. löcherseitige Blockschicht (typischerweise dünner als Schicht 7) aus einem Material, dessen Bandlagen zu den Bandlagen der sie umgebenden Schichten passt,
7. p-dotierte Löcher injizierende und transportierende Schicht,
8. Elektrode, löcherinjizierend (Anode=Pluspol), vorzugsweise transparent,
9. Kapselung, zum Ausschluß von Umwelteinflüssen.

Es ist auch im Sinne der Erfindung, wenn nur eine Blockschicht Verwendung findet, weil die Bandlagen der injizierenden und transportierenden Schicht und der Lichtemissionsschicht bereits auf einer Seite zueinander passen. Auch ist unter Umständen nur die Löchertransportschicht dotiert. Des weiteren können die Funktionen der Ladungsträgerinjektion und des Ladungsträgertransports in den Schichten 3 und 7 auf mehrere Schichten aufgeteilt sein, von denen mindestens eine dotiert ist. Wenn die dotierte Elektronentransport-schicht sich nicht unmittelbar an der Elektrode befindet, so müssen alle Schichten zwischen der dotierten Schicht und der Elektrode so dünn sein, dass sie effizient von Ladungsträgern durchtunnelt werden können. Diese Schichten können dicker sein, wenn sie eine sehr hohe Leitfähigkeit aufweisen (der Bahnwiderstand dieser Schichten muss geringer sein als der der benachbarten dotierten Schicht). Dann sind die Zwischenschichten im Sinne der Erfindung als ein Teil der Elektrode zu betrachten. Die molaren Dotierungskonzentrationen liegen typischerweise im Bereich von 1:10 bis 1:10000. Falls die Dotanden wesentlich kleiner sind als die Matrixmoleküle, können in Ausnahmefällen auch mehr Dotanden als Matrixmoleküle in der Elektronentransportshicht sein (bis 5:1). Die Dotanden können organisch oder anorganisch sein.

Die Erfindung wird nachfolgend an Hand von Ausführungsbeispielen noch näher erläutert. In den Zeichnungen ist folgendes dargestellt:
- Bild 1: ein Energiediagramm einer invertierten OLED in der bisher üblichen Ausführungsform (ohne Dotierung, die Zahlenangaben beziehen sich auf die oben beschriebene Schichtstruktur einer invertierten OLED),
- Bild 2: ein Energiediagramm einer invertierten dotierten OLED mit Blockschichten.

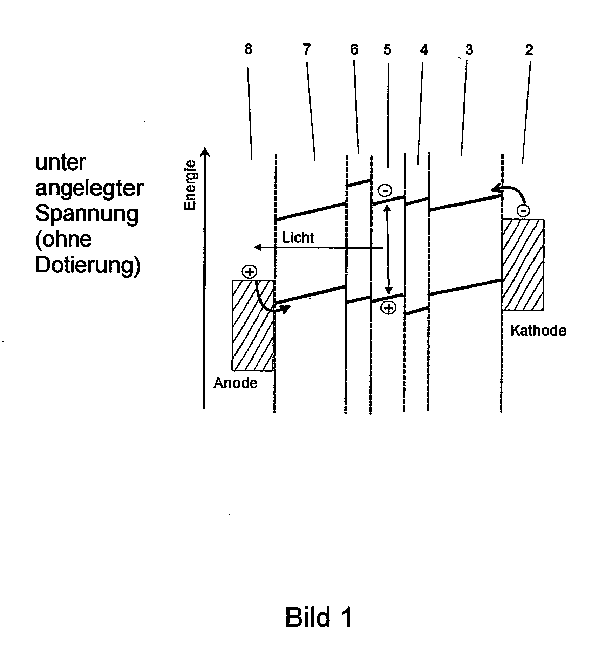

In der in Bild 1 gezeigten Ausführungsform tritt keine Raumladungszone am löcherinjizierenden Kontakt auf Diese Ausführung verlangt nach einer niedrigen energetischen Barriere für die Löcherinjektion. Dies kann unter Umständen mit verfügbaren Materialien nicht erreicht werden. Die Injektion von Löchern aus der Anode ist daher nicht so effektiv wie für die herkömmliche Struktur, bei der die Anode hinsichtlich ihrer Austrittsarbeit modifiziert werden kann. Die OLED weist eine erhöhte Betriebsspannung auf.

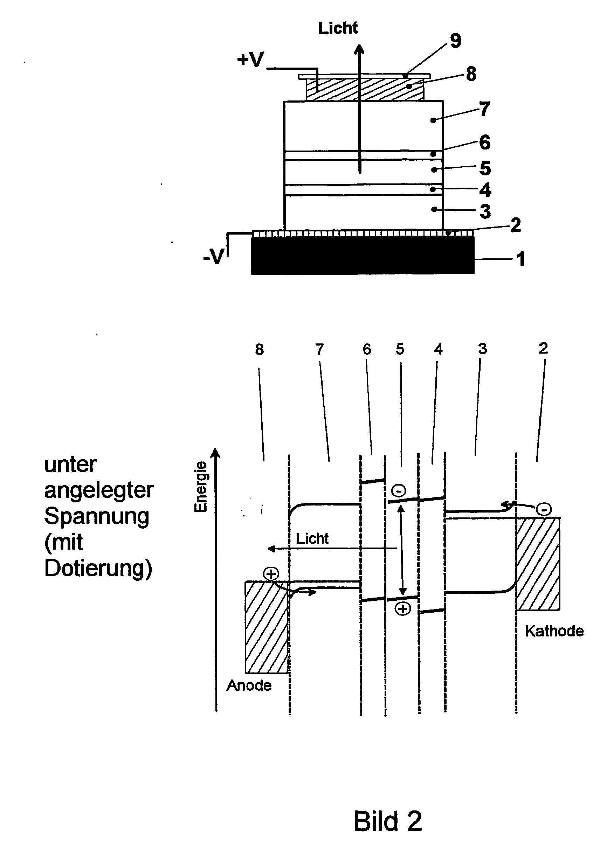

Erfindungsgemäß wird der Nachteil der bisherigen Strukturen durch invertierte OLEDs mit dotierten Injektions- und Transportschichten, ggf. in Verbindung mit Blockschichten, vermieden. Bild 2 zeigt eine entsprechende Anordnung. Hierbei ist die löcherinjizierende und - leitende Schicht 7 dotiert, so dass sich an der Grenzschicht zum Kontakt (Anode 8) eine Raumladungszone ausbildet. Bedingung ist, dass die Dotierung hoch genug ist, dass diese Raumladungszone leicht durchtunnelt werden kann. Dass solche Dotierungen möglich sind, wurde in der Literatur für nicht invertierte Leuchtdioden bereits gezeigt (X.Q. Zhou et al., Appl. Phys. Lett. 78, 410 (2001); J. Blochwitz et al., Organic Elecronics (2001), in press)

Diese Anordnung zeichnet sich durch folgende Vorzüge aus:
- hervorragende Injektion der Ladungsträger von der Anode in die p-dotierten Ladungsträgertransportschichten
- Unabhängigkeit von der detaillierten Präparation des löcherinjizierenden Materials 8
- Möglichkeit, für Schicht 8 auch ein Material mit vergleichsweise hoher Barriere für die Löcherinjektion zu wählen.

Als ein bevorzugtes Ausführungsbeispiel soll hier eine Lösung angegeben werden, bei der nur auf der Löcherseite die Kombination aus p-dotierter Injektions- und Transportschicht und Blockschicht eingesetzt wird. Die OLED weist folgende Schichtstruktur auf:
- Substrat 1, z.B. Glas,
- Kathode 2: 1nm LiF in Kombination mit Aluminium (LiF verbessert die Injektion am Kontakt),
- elektrolumineszierende und (in diesem Fall) herkömmliche elektronenleitende Schicht 5:
   65nm Alq₃, evtl. zu ersetzen durch 30nm Alq₃ und 15nm Alq₃, dotiert mit ca. 1% eines Emitterfarbstoffs wie Quinacridon,
- löcherseitige Blockschicht 6: 5nm Triphenyldiamin (TPD),
- p-dotierte Schicht 7: 100nm Starburst TDATA 50:1 dotiert mit F₄-TCNQ,
- transparente Elektrode (Anode 8): Indium-Zinn-Oxid (ITO).

Die gemischte Schicht 7 wird in einem Aufdampfprozeß im Vakuum in Mischverdampfung hergestellt. Prinzipiell können solche Schichten auch durch andere Verfahren hergestellt werden, wie z.B. einem Aufeinanderdampfen der Substanzen mit anschließender möglicherweise temperaturgesteuerter Diffusion der Substanzen ineinander; oder durch anderes Aufbringen (z.B. Aufschleudern) der bereits gemischten Substanzen im oder außerhalb des Vakuums. Die Blockschicht 6 wurde ebenfalls im Vakuum aufgedampft, kann aber auch anders hergestellt werden, z.B. durch Aufschleudem innerhalb oder außerhalb des Vakuums.

In einem weiteren bevorzugten Ausführungsbeispiel kann sich zusätzlich zwischen der Kathode **2** und der elektrolumineszierenden Schicht **5** eine n-dotierte Schicht **3** befinden. Die Dotierung kann, wie oben beschrieben, durch eine Mischverdampfung zweier organischer Materialien (Molekülsorten) oder durch Einbringung von Metallatomen in die organische Schicht bestehen (wie in Patent Anmeldung DE 100 58 578.7, eingereicht am 25.11.2000, nachveröffentlicht). Als erfindungskonformes Beispiel sei hier die Dotierung von Alq₃ mit Li genannt (Patent US 6,013,384 (J. Kido et al.), eingereicht am 22.1.1998; J. Kido et al., Appl. Phys. Lett. 73, 2866 (1998)). Durch die erfindungsgemäße Anwendung einer solchen Schicht in einer invertierten OLED-Struktur wird der positive Effekt einer Lithium-fluorid Schicht zwischen der elektronentransportierenden Schicht und der Metallschicht der Kathode, welcher bei einem nicht invertierten Aufbau der OLED erreicht wird (hier ist das Aufdampfen "heißer" Metallatome auf LiF wichtig um den gewünschten Effekt auf die Elektroneninjektion zu erreichen, siehe z.B. M.G. Mason, J. Appl. Phys. 89, 2756 (2001)), auch für die invertierte Struktur erreicht. Die LiF Schicht senkt die Austrittsarbeit des Kathodenmaterials (hier Aluminium) und die Li Dotierung der elektronentransportierenden Schicht (typischerweise und erfindungskonform in einer Konzentration zwischen 5:1 und 1:10 Li-Atome zu Alq₃-Moleküle) ermöglicht eine Bandverbiegung an der Grenzfläche zur Kathode, welche eine effiziente Injektion von Elektronen erlaubt, analog zum Falle der Löcherinjektion in die p-dotierte Löchertransportschicht.

Die erfindungskonforme Anwendung dotierter Schichten erlaubt es, die gleichen niedrigen Betriebsspannungen und hohen Effizienzen in einer invertierten Struktur mit Lichtemission durch den Deckkontakt zu erreichen wie sie bei einer herkömmlichen Struktur mit Emission durch das Substrate auftreten. Dies liegt, wie beschrieben, an der effizienten Löcherinjektion, welche dank der Dotierung relativ unabhängig von der exakten Austrittsarbeit des transparenten Anodemnaterials ist. Damit lassen sich hocheffiziente Displays auf herkömmlichen Halbleitersubstraten aufbauen.

Obwohl nur einige bevorzugte Anwendungen beschrieben worden sind, ist es für den Fachmann offensichtlich, dass viele Modifikationen und Variationen der vorgestellten Erfindung möglich sind, welche im Sinne der Erfindung sind. Zum Beispiel können andere transparente Kontakte als ITO als Anodenmaterialien verwendet werden (z.B. wie in H. Kim et al., Appl. Phys. Lett. 76, 259 (2000); H. Kim et al., Appl. Phys. Lett. 78, 1050 (2001)).

Weiterhin wäre es erfindungskonform die transparente Anode aus einer hinreichend dünnen Schicht eines nicht transparenten Metalles (z.B. Silber oder Gold) und einer dicken Schicht eines transparenten leitfähigen Materials zusammenzusetzen.

### Bezugszeichenliste

- 1 -: Substrat
- 2 -: Kathode
- 3 -: Elektronentransportschicht
- 4 -: Blockschicht
- 5 -: lichtemittierende Schicht
- 6 -: Blockschicht
- 7 -: Löchertransportschicht
- 8 -: Anode
- 9 -: Schutzschicht

## Patentansprüche

1. Lichtemittierendes Bauelement mit organischen Schichten, insbesondere organische Leuchtdiode, wobei in einer invertierten Struktur ein Substrat (1), wenigstens eine lichtemittierende Schicht (5) und wenigstens eine Löchertransportschicht (7), eine auf das Substrat aufgebrachte Kathode (2) und eine Anode (8) gebildet sind, durch die die Lichtemission erfolgt, **dadurch gekennzeichnet, dass** die Löchertransportschicht (7) mit einem organischen Material p-dotiert und an der Anode (8) gebildet ist, wobei die Anode (8) auf der Löchertransportschicht (7) angeordnet ist, wobei die molare Dotierungskonzentration in der Löchertransportschicht (7) im Bereich von 1:10 bis 1:10000 bezogen auf das Verhältnis organischer Dotierungsmoleküle zu Matrixmoleküle liegt, wobei die Schichtdicke der Löchertransportschicht gröβer 40mn ist und die Anode (P) aus Indium- oder Zium-Oxid einem anderen transparenten entarteten Oxidhalbleiter oder metallisch ist.

2. Lichtemittierendes Bauelement nach einem der Ansprüche 1, **dadurch gekennzeichnet, dass** zwischen der Löchertransportschicht (7) und der lichtemittierenden Schicht (5) eine für Löcher eine niedrige und für Elektronen eine hohe Barriere bildende Blockschicht vorgesehen ist.

3. Lichtemittierendes Bauelement nach einem der Ansprüche 1 bis 2, **dadurch gekennzeichnet, dass** zwischen der Kathode (2) und der lichtemittierenden Schicht (5) eine Elektronentransportschicht (3) vorgesehen ist.

4. Lichtemittierendes Bauelement nach Anspruch 3, **dadurch gekennzeichnet, dass** die Elektronentransportschicht (3) dotiert ist.

5. Lichtemittierendes Bauelement nach einem der Ansprüche 3 oder 4, **dadurch gekennzeichnet**, das eine für Elektronen eine niedrige und für Löcher eine hohe Barriere bildende Blockschicht (4) zwischen der Elektronentransportschicht (3) und der lichtemittierenden Schicht (5) und eine für Löcher eine niedrige und für Elektronen eine hohe Barriere bildende Blockschicht (6) zwischen der lichtemittierenden Schicht (5) und der p-dotierten Löchertransportschicht (7) vorgesehen ist.

6. Litchtemitterendes Bauelement nach einem der Ansprüche 3 bis 5, **dadurch gekennzeichnet, dass** zwischen Elektronentransportschicht (3) und Kathode (2) ein kontaktverbessernde Schicht vorgesehen sind.

7. Lichtemittierendes Bauelement nach einem der Ansprüche 1 bis 6, **dadurch gekennzeichnet, dass** eine elektroneninjizierende Kathode (2) auf einem transparenten Substrat (1) vorgesehen ist.

8. Lichtemittierendes Bauelement nach einem der Ansprüche 1 bis 7, **dadurch gekennzeichnet, dass** die lichtetemittierende Schicht (5) eine Mischschicht aus mehreren Materialien ist.

9. Lichtemittierendes Bauelement nach einem der Ansprüche 1 bis 8, **dadurch gekennzeichnet, dass** die p-dotiertc Löchertransportschicht (7) aus einer organischen Hauptsubstanz und einer Akzeptoren bereitstellen organischen Dotiersubstanz besteht.

10. Lichtemittierendes Bauelement nach einem der Ansprüche 1 bis 9, **dadurch gekennzeichnet, dass** die Anode (8) mit einer Schutzschicht (9) versehen ist.

11. Lichtemittierendes Bauelement nach einem der vorangehenden Ansprüche, **dadurch gekennzeichnet, dass** über der semitransparenten metallischen Anode (3) eine weitere transparente Kontaktschicht zur Erhöhung der Querleitung aufgebracht ist.

12. Lichtemittierendes Bauelement nach einem der Ansprüche 3 oder 4 bis 11 soweit auf Anspruch 5 rückbezogen, **dadurch gekennzeichnet**, das die Elektronentransportschicht (3) durch die Mischung einer organischen Hauptsubstanz und einer Donatoren bereitstellenden Dotiersubstanz n-artig dotiert ist.

13. Lichtemittierendes Bauelement nach Anspruch 10, **dadurch gekennzeichnet, dass** die Reihenfolge aus p-dotierter Löchertransportschjcht (7) und transparenter Anode (8) mehrfach in einem Bauelement vorgesehen ist.

14. Lichtemittierendes Bauelement nach einem der Ansprüche 4 oder 5 bis 13 soweit auf Anspruch 6 rückbezogen, **dadurch gekennzeichnet, dass** die molare Konzentration der Beimischung in der Elektronentransportschicht (3) im Bereich 1:100.000 bis 5:1 bezogen auf das Verhältnis Dotierungsmotekütezu Hauptsubstanzmoleküle liegt.

15. Lichtemittierendes Bauelement nach einem der Ansprüche 1 bis 14, **dadurch gekennzeichnet**, das die Schichtdicken der Elektronentransportschicht (3), der elektrolumineszierenden Schicht (5) und der Blockschichten (4, 6) im Bereich 0.1 nm bis 50µm liegt.

## Claims

1. Light-emitting comprising organic layers, in particular an organic light-emitting diode, comprises in an inverse structure a substrate (1), at least one light-emitting layer (5) and at least one hole transport layer (7), a cathode (2) at the substrate and an anode (8) to emit light, **characterized in that** the hole transport layer (7) at the anode (8) is p-doped with an organic material with a molar doping concentration of 1:10 to 1:10000 referred to the ratio of doping molecules to the matrix molecules, wherein the thickness of the hole transport layer (7) is greater than 40nm and the anode (8) consist of indium or tin oxide or another transparent oxidic semiconductor material or a metallic material.

2. Light-emitting component according to claim 1, **characterized in that** between the hole transport layer (7) and the light-emitting layer (5) a block layer forming a low barrier for holes and a high barrier for electrons is provided.

3. Light-emitting component according to claim 1 or 2, **characterized in that** between the cathode (2) and the light-emitting layer (5) an electron transport layer is provided.

4. Light-emitting component according to claim 3, **characterized in that** the electron transport layer (3) is doped.

5. Light-emitting component according to anyone of the claims 3 to 4, **characterized in that** a block layer (4) forming a low barrier for holes and high barrier for electrons is provided between the electron transport layer (3) and the light-emitting layer (5) and a block layer (6) forming a low barrier for holes and a high barrier for electrons between the light-emitting layer (5) and the p-doped hole transport layer (7) is provided.

6. Light-emitting component according to anyone of the claims 3 to 5, **characterized in that** between the electron transport layer (3) and the cathode (2) a contact improving layer is provided.

7. Light-emitting component according to anyone of the claims 1 to 6, **characterized in that** an electron injection cathode (2) is provided on a transparent substrate.

8. Light-emitting component according to anyone of the claims 1 to 7, **characterized in that** the light-emitting layer (5) is a mixed layer of several materials.

9. Light-emitting component according to anyone of the claims 1 to 8, **characterized in that** the p-doped hole transport layer (7) consists of an organic main substance and an acceptor providing organic doping substance.

10. Light-emitting component according to anyone of the claims 1 to 9, **characterized in that** the anode (8) is provided with a protective layer (9).

11. Light-emitting component according to anyone of the preceding claims, **characterized in that** on the semitransparent metallic anode (3) an additional transparent contact layer is applied to enhanced the transverse conduction.

12. Light-emitting component according to anyone of the claims 3 or 4 to 11, as far as referred to claim 3, **characterized in that** the electron transport layer (3) is n-doped by mixing an organic main substance and a donor like doping substance.

13. Light-emitting component according to claim 10, **characterized in that** the sequence of p-doped hole transport layer (7) and transparent anode (8) is repeated several times in one component.

14. Light-emitting component according to anyone of the claims 4 or 5 to 13 as far as referred to claim 4, **characterized in that** the molar concentration of the admixing in the electron transport layer (3) is in the range of 1:100.000 to 5:1 referred to the ratio of doping molecules to main substance molecules.

15. Light-emitting component according to anyone of the claims 1 to 14, **characterized in that** the thickness of the layer of the electron transport layer (3), the electroluminescent layer (5) and the block layers (4, 6) is in the range of 0.1nm to 50µm.

## Revendications

1. Composant électroluminescent avec des couches organiques, en particulier diode électroluminescente organique, étant donné que sont formés, dans une structure inversée, un substrat (1), au moins une couche électroluminescente (5) et au moins une couche de transport de trous (7), une cathode (2) appliquée sur le substrat et une anode (8) à travers laquelle se produit l'émission de lumière, **caractérisé en ce que** la couche de transport de trous (7) est dopée de type p avec un matériau organique et formée sur l'anode (8), l'anode (8) étant disposée sur la couche de transport de trous (7), étant donné que la concentration de dopage molaire dans la couche de transport de trous (7) est située dans la plage de 1:10 à 1:10000 en référence au rapport de molécules de dopage organiques avec les molécules matricielles, l'épaisseur de couche de la couche de transport de trous étant supérieure à 40 mm et l'anode (8) étant en oxyde d'indium ou oxyde d'étain, en un autre semi-conducteur à oxyde dégénéré transparent ou métallique.

2. Composant électroluminescent selon la revendication 1, **caractérisé en ce qu'**est prévue entre la couche de transport de trous (7) et la couche électroluminescente (5) une couche de blocage formant une barrière basse pour les trous et élevée pour les électrons.

3. Composant électroluminescent selon l'une quelconque des revendications 1 à 2, **caractérisé en ce qu'**est prévue entre la cathode (2) et la couche électroluminescente (5) une couche de transport d'électrons (3).

4. Composant électroluminescent selon la revendication 3, **caractérisé en ce que** la couche de transport d'électrons (3) est dopée.

5. Composant électroluminescent selon l'une quelconque des revendications 3 ou 4, **caractérisé en ce qu'**est prévue une couche de blocage (4) formant une barrière basse pour les électrons et élevée pour les trous entre la couche de transport d'électrons (3) et la couche électroluminescente (5), et une couche de blocage (6) formant une barrière basse pour les trous et élevée pour les électrons entre la couche électroluminescente (5) et la couche de transport de trous (7) dopée de type p.

6. Composant électroluminescent selon l'une quelconque des revendications 3 à 5, **caractérisé en ce qu'**est prévue entre la couche de transport d'électrons (3) et la cathode (2) une couche qui améliore le contact.

7. Composant électroluminescent selon l'une quelconque des revendications 1 à 6, **caractérisé en ce qu'**est prévue une cathode (2) à injection d'électrons sur un substrat transparent (1).

8. Composant électroluminescent selon l'une quelconque des revendications 1 à 7, **caractérisé en ce que** la couche électroluminescente (5) est une couche mixte en plusieurs matériaux.

9. Composant électroluminescent selon l'une quelconque des revendications 1 à 8, **caractérisé en ce que** la couche de transport de trous (7) dopée de type p se compose d'une substance principale organique et d'une substance de dopage organique présentant des accepteurs.

10. Composant électroluminescent selon l'une quelconque des revendications 1 à 9, **caractérisé en ce que** l'anode (8) est dotée d'une couche de protection (9).

11. Composant électroluminescent selon l'une quelconque des revendications précédentes, **caractérisé en ce qu'**est appliquée au-dessus de l'anode métallique semi-transparente (3) une autre couche de contact transparente afin d'améliorer la conductivité transversale.

12. Composant électroluminescent selon l'une quelconque des revendications 3 ou 4 à 11, dans la mesure où ces dernières s'appuient sur la revendication 5, **caractérisé en ce que** la couche de transport d'électrons (3) est dopée de type n par le mélange d'une substance principale organique avec une substance de dopage présentant des donateurs.

13. Composant électroluminescent selon la revendication 10, **caractérisé en ce que** la succession de couche de transport de trous (7) dopée de type p et anode transparente (8) est prévue à plusieurs reprises dans un composant.

14. Composant électroluminescent selon l'une quelconque des revendications 4 ou 5 à 13, dans la mesure où ces dernières s'appuient sur la revendication 6, **caractérisé en ce que** la concentration molaire du mélange dans la couche de transport d'électrons (3) est située dans la plage de 1:100.000 à 5:1 en référence au rapport de molécules de dopage avec les molécules de la substance principale.

15. Composant électroluminescent selon l'une quelconque des revendications 1 à 14, **caractérisé en ce que** les épaisseurs de couches de la couche de transport d'électrons (3), de la couche électroluminescente (5) et des couches de blocage (4, 6) sont situées dans la plage de 0,1 nm à 50 µm.
